# EUROPÄISCHE PATENTSCHRIFT

(11) **EP 1 552 730 B1**
(45) Veröffentlichungstag und Bekanntmachung des Hinweises auf die Patenterteilung: **20.06.2007**
(21) Anmeldenummer: 03757973.7
(22) Anmeldetag: 14.10.2003
(51) Int. Cl.: H05K 3/28, B05C 1/08

(54) **VERFAHREN UND VORRICHTUNG ZUR BESCHICHTUNG VON LEITERPLATTEN MIT LASER-STRUKTURIERBAREN, THERMISCH HÄRTBAREN LÖTSTOPPLACKEN SOWIE GALVANORESISTEN**
METHOD AND DEVICE FOR COATING PRINTED BOARDS WITH SOLDER STOP LACQUERS AND GALVANORESISTS THAT CAN BE LASER-STRUCTURED AND THERMALLY HARDENED
PROCEDE ET DISPOSITIF POUR APPLIQUER DES LAQUES D'ARRET DE SOUDURE OU DES GALVANORESISTS THERMODURCISSABLES ET STRUCTURABLES PAR LASER SUR DES CARTES IMPRIMEES

(30) Priorität: 14.10.2002 DE 10247861; 29.10.2002 DE 10250485; 12.11.2002 DE 10252897; 05.01.2003 DE 10300344
(43) Veröffentlichungstag der Anmeldung: 13.07.2005
(73) Patentinhaber: ATOTECH Deutschland GmbH, 10553 Berlin (DE)
(72) Erfinder: SCHÄFER, Hans-Jürgen, 47057 Duisburg (DE)
(74) Vertreter: Albrecht, Thomas
(86) Internationale Anmeldenummer: PCT/EP2003/011369
(87) Internationale Veröffentlichungsnummer: WO 2004/036967

(56) Entgegenhaltungen:
- EP-A- 1 121 008
- DE-A- 3 816 614
- DE-A- 19 516 193
- DE-A- 19 704 260
- US-A- 5 863 620

## Beschreibung

### Technisches Gebiet

Die Erfindung betrifft ein Verfahren und eine Vorrichtung zur Beschichtung von Leiterplatten mit Laser-strukurierbaren, thermisch härtbaren Lötstopplacken sowie Galvanoresisten.

### Stand der Technik

Leiterplatten werden mit Lötstopplacken, insbesondere mit fotosensiblen Lötstopplacken, beschichtet, um die Leiter zu schützen und nur die zu lötenden Bohrungen und Lotpads für das Lotzinn freizulassen. Genügte bis 1975 noch der Siebdruck, so hat sich ab diesem Zeitpunkt der fotosensible Lötstopplack durchgesetzt. Die erforderliche Genauigkeit bei den immer komplexer werdenden Schaltungen konnte nur durch das Fotostrukturierungsverfahren sichergestellt werden. Diese Lacke wurden z.B. im Vorhanggießverfahren einseitig aufgetragen. Dies wird in der europäischen Patentanmeldung EP 0 002 040 A1 beschrieben.

Diese Applikationstechnologie führt zu einigen Problemen. Diese sind insbesondere die Kantenabdeckung hoher Feinleiter mit einer Breite und Höhe von 100 µm. Die mit einer Viskosität von 500 bis 1200 mPa·s aufgetragenen Lacke fließen insbesondere beim Trocknen durch die damit verbundene Viskositätserniedrigung von den Leiterkanten ab. Dieses Problem wurde durch Verwendung leicht verdunstender Lösungsmittel und hoher Thixotropie durch Füllstoffzusätze gelöst. Die beschichteten Leiterplatten werden zunächst in einem Paternosterofen bei niedriger Temperatur abgelüftet, wobei der Lack auf den Leiter auftrocknet. Anschließend erfolgt die eigentliche Trocknung mittels heißer Umluft.

Das Problem der Beschichtung hoher Leiter wurde auch insbesondere durch die Sprühbeschichtung gelöst. Allen Beschichtungsverfahren ist jedoch die Mitbeschichtung von Bohrungen gemeinsam. Der dort eingeflossene Lack wird nach der Fotostrukturierung im Entwicklerbad herausgelöst. Dies führt gemeinsam mit den freientwickelten Lotpads zu erheblicher Abwasserbelastung. Die Lackqualität hat insbesondere durch die alkalischen Entwicklungsprozesse gelitten, da diese dann über entsprechende Carboxylgruppen verfügen mussten, welche die Feuchtigkeitsaffinität verschlechterten. Die für die Fotostrukturierung erforderlichen Acrylate beeinträchtigen den Erweichungsbereich des Lötstopplackes, was sich insbesondere beim Löten mit bleifreiem Lot bei höheren Löttemperaturen nachteilig bemerkbar macht.

Die weiter fortschreitende Miniaturisierung stellt diese Generation von Lötstopplacken vor neue Probleme. Hierbei macht sich insbesondere die Unsicherheit bei der Entwicklung negativ bemerkbar. All diese Probleme können durch die Verwendung eines mittels Laser-strukturierbaren Lötstopplackes gelöst werden. Hiermit werden nur die Lotpads und die Restringe der Bohrungen mittels Laser (z.B. CO₂-Laser UV-Laser) vom Lack befreit. Ein Entwicklungsprozess ist nicht erforderlich. Somit entsteht auch kein Polymerabfall. Der Laser ist sehr genau positionierbar. Probleme wie beim Filmversatz können nicht auftreten. Der Einsatz eines nicht fotosensiblen thermisch härtbaren Lötstopplackes scheitert zur Zeit daran, dass kein Applikationsverfahren verfügbar ist, mit dem eine Lackfreiheit der Bohrungen gewährleistet werden kann.

In der EP 0 766 908 wird zur Herstellung von Multi-Chip-Modulen ein beidseitiges Walzenbeschichtungsverfahren für fotopolymerisierbare Beschichtungsmittel beschrieben, bei dem die Dosierwalzen auf 25 bis 60°C erwärmt und die Auftragswalzen auf 5 bis 20°C gekühlt werden können. Die Erwärmung des Lackes führt zur Verdunstung und zum Auftrocknen der nicht übertragenen Lackschicht auf die Gummioberfläche der Auftragswalze. Eine Kühlung führt zur Abscheidung von Kondensat. Die erzielte Leiterkantenabdeckung bei 50 µm Leiterhöhe und 50 µm Lackschichtdicke betrug 13 µm. Die Bohrungen waren nicht lackfrei. Die Beschichtungsviskosität ist mit 20.000 bis 100.000 mPa·s so hoch, dass nur mit profilierten Walzen bei Schichtdicken von 50 bis 200 µm gearbeitet werden kann. Die Beschichtungsgeschwindigkeit von 5 bis 20 m pro min ist für eine Beschichtung mit Lötstopplacken zu hoch, da keine gute Kantenabdeckung erzielt werden kann.

Diese hohe Beschichtungsgeschwindigkeit wird auch in der DE 101 31 027 A1 mit dem Titel: Verfahren und Vorrichtung zur Hochgeschwindigkeitsbeschichtung von Holz/Kunststoff- und Metalloberflächen beschrieben. Hierbei werden vorzugsweise strahlenhärtbare Pulverlacke mittels einer Schmelzwalze aus einem Pulverlackvorrat gefördert. Dies ist mit rein thermisch härtenden Lacken nicht durchführbar, da es dann zu Härtungsreaktionen und Verklumpungen kommt. Für die Beschichtung der Unterseite wird eine Schmelzwalze in einen Pulverlackbehälter ohne Dosierung eingetaucht. Dies führt bei thermisch härtbaren Lacken zur Aushärtung des Vorrates.

Gleiches gilt für das in der Patentschrift EP 0 698 233 B1 beschriebene Verfahren, das den Auftrag von strahlenhärtbaren Beschichtungsmitteln aus der Schmelze beschreibt. Keines der bekannten Verfahren ist in der Lage die erfindungsgemäße Zielsetzung zu erfüllen. Sie beziehen sich ausschließlich auf strahlenhärtbare Lacksysteme. Die für den Leiterplattentransport erforderliche Lackfreiheit der Ränder kann ebenfalls nicht realisiert werden. Die marktgängigen Lötstopplacke enthalten mineralische Füllstoffe zur Erhöhung der Viskosität, insbesondere um ein Ablaufen des Lackes von den Leiterflanken zu verhindern. Diese mineralischen Füllstoffe sind üblicherweise mit einem Gewichtsanteil von 20 bis 50% in den Lötstopplacken enthalten. Wenn diese marktgängigen Lötstopplacke mittels Laser strukturiert werden, so bleibt ein Ascherückstand auf den Lotpads zurück, der sich pilzartig aufbaut. Dies verhindert eine einwandfreie Lötung, zumal die Reinigung schwierig ist.

Eine Lackfreiheit der Bohrungen wird mit den derzeitigen Applikationsverfahren nicht sichergestellt.

Die EP 1 121 008 A1 betrifft eine mehrschichtige gedruckte Leiterplatte und ein Verfahren zur Herstellung derselben. Geeignete Lötstopplacke und Galvanoresiste werden auf Seite 9 in den Zeilen 29 bis 37 und in der Passage von Seite 11, Zeile 50 bis Seite 12, Zeile 42 dieser Anmeldung beschrieben.

Der Erfindung liegt die Aufgabe zugrunde, die vorgenannten Probleme, die im Stand der Technik bei Beschichtungen von Leiterplatten auftreten, zu lösen. Insbesondere liegt der Erfindung die Aufgabe zugrunde, einen bevorzugt thermisch härtbaren Lötstopplack und Galvanoresist sowie ein Verfahren und eine Vorrichtung verfügbar zu machen, das bzw. die eine rückstandsfreie Strukturierung mittels Lasern ermöglicht und bei dem mit niedriger Lackschichtdicke eine gute Kantenabdeckung bei schmalen und hohen Leitern, eine fehlerfrei geschlossene Lackoberfläche sowie eine gleichzeitige Lackfreiheit der Bohrungen und der Leiterplattenränder gewährleistet werden kann.

Gegenstand der Erfindung ist eine Vorrichtung zur Beschichtung von Leiterplatten mit einem Lötstopplack bzw. Galvanoresist, umfassend mindestens eine Walzenbeschichtungsanlage mit einer oberen gummierten Führungswalze, einer unteren gummierten Auftragswalze, einer mit der Auftragswalze einen Dosierspalt ausbildenden Dosierwalze, einem oberhalb der Walzenbeschichtungsanlage angeordneten Vorratsbehälter für den Lötstopplack bzw. Galvanoresist, Mittel zum Transport der Leiterplatten, Mittel zum Trocknen des Lötstopplacks und eine Einrichtung zum Wenden der beschichteten Leierplatten, wobei die Walzenbeschichtungsanlage nur über eine Beschichtungseinheit zur Beschichtung der Leiterplattenunterseite verfügt.

Bevorzugte Ausführungsformen der erfindungsgemäßen Vorrichtung sind Gegenstand der Patentansprüche 2 bis 6.

Des Weiteren betrifft die Erfindung ein Verfahren zur Beschichtung von Leiterplatten mit einem Lötstopplack bzw. Galvanoresist, das die folgenden Stufen umfasst:
(i) Zuführen der Leiterplatte zu einer Walzenbeschichtungsanlage, wobei die Walzenbeschichtungsanlage nur über eine Beschichtungseinheit zur Beschichtung der Substratunterseite verfügt,
(ii) Zudosieren des Lötstopplacks bzw. Galvanoresists mit einer Viskosität von 4.000-15.000 mPa·s bei 25°C oder eines Pulverlacks,
(iii) Auftragen des Lacks auf die Unterseite der Leiterplatte,
(iv) Trocknen der beschichteten Leiterplatte für einen Zeitraum und bei einer Temperatur, die ausreichend sind, um die Viskosität des Lacks auf unter 300 mPa·s bzw. des Pulverlacks auf unter 500 mPa·s zu erniedrigen, den Lack zu verfestigen und klebfrei zu machen, und
(v) Wenden der Leiterplatte und Durchführen der Stufen (i) bis (iv) in derselben oder einer weiteren Walzenbeschichtungsanlage.

Bevorzugte Ausführungsformen des erfindungsgemäßen Verfahrens sind Gegenstand der Patentansprüche 8 bis 16.

Schließlich betrifft die Erfindung einen mittels Laser strukturierbaren Lötstopplack und Galvanoresist, der dadurch gekennzeichnet ist, dass er einen Festkörpergehalt von 50-100 Gew.-% aufweist und ein thermisch härtbarer, pulverförmiger Lötstopplack ist, der eine Viskosität von 10.000-15.000 mPa·s bei einer Temperatur von 80-120°C aufweist.

### Kurze Beschreibung der Figuren

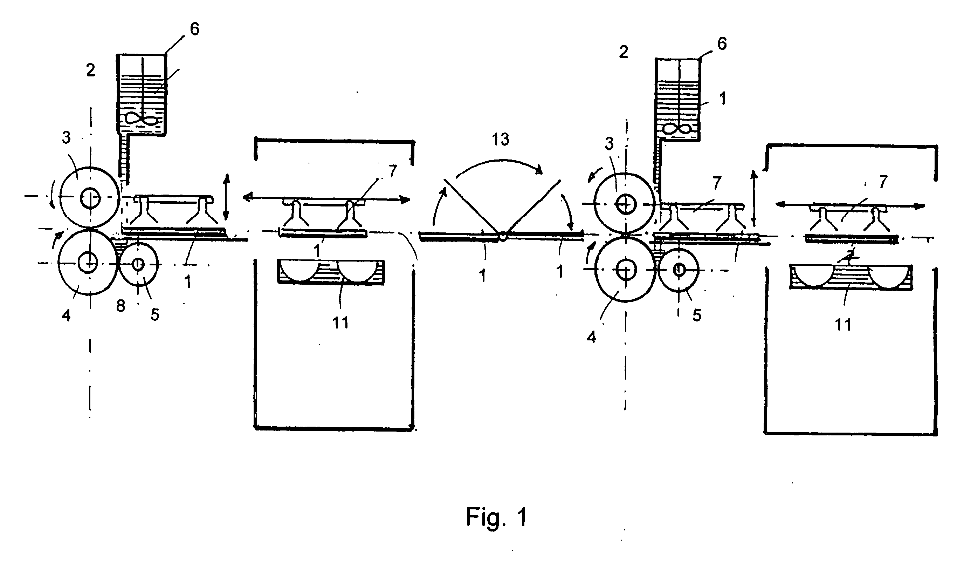

Figur 1 zeigt schematisch die erfindungsgemäße Vorrichtung.

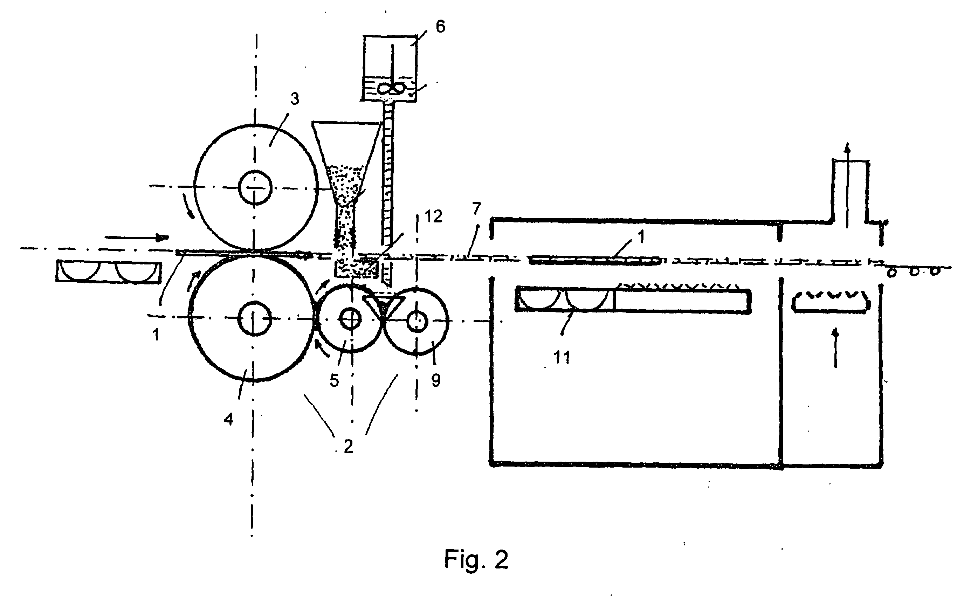

Figur 2 zeigt eine weitere Ausführungsform der erfindungsgemäßen Vorrichtung zur Verwendung mit Pulverlacken.

Figur 3 zeigt schematisch eine nach im Stand der Technik bekannten Verfahren beschichtete Leiterplatte.

Figur 4 zeigt eine mit dem erfindungsgemäßen Verfahren beschichtete Leiterplatte.

Hierin bedeuten:
(1) Leiterplatte
(2) Walzenbeschichtungsanlage
(3) Gummierte Führungswalze
(4) Gummierte Auftragswalze
(5) Dosierwalze
(6) Vorratsbehälter
(7) Mittel zum Transport der Leiterplatten
(8) Rakel
(9) Dosierwalze
(10) Kupferleiter
(11) Mittel zum Trocknen des Lötstopplacks
(12) Siebkasten
(13) Wender
(14) Leiterkantenabdeckung

### Detaillierte Beschreibung der Erfindung

Die Erfindung wird im Nachfolgenden näher erläutert: Die Auftragung des Lacks kann nach dem Fachmann an sich bekannten Verfahren erfolgen, solange die dabei verwendete Beschichtungsanlage nur über eine Beschichtungseinheit zur Beschichtung der Substratunterseite verfügt.

Bei Verwendung der Vorrichtung nach Anspruch 1 wird beispielsweise ein Lötstopplack mit einer Viskosität von bevorzugt 5.000 bis 15.000 mPa·s bei 25°C und einem Festkörpergehalt von 50 bis 100%, der sowohl thermisch wie auch strahlenhärtbar ist und bevorzugt keine oder nur geringe Mengen an mineralischen Füllstoffen enthält, zusammen mit einer beidseitig mit Leitern und mit Bohrungen (z.B. zur Aufnahme von bedrahteten Bauelementen) versehene Leiterplatte (1) einer ersten Walzenbeschichtungsanlage (2) zugeführt, die aus einer oberen gummierten Führungswalze (3), einer unteren gummierten Auftragswalze (4) und einer mit dieser einen Dosierspalt ausbildenden Dosierwalze (5) besteht, zwischen denen gegebenenfalls eine keilförmige Rakel (8) zur Lackfreimachung der Leiterplattenränder angeordnet ist. Zwischen der Dosierwalze (5) und der Auftragswalze (4) wird aus einem oberhalb der Walzenbeschichtungsanlage (2) angeordneten Vorratsbehälter (6) ein hochviskoser Lötstopplack zudosiert. Über die glatte (Rz = 5 µm bis 10 µm) und weiche (20 bis 40 Shore A) Gummioberfläche wird nun dieser Lötstopplack mit einer Viskosität von bevorzugt 5.000 bis 15.000 mPa·s vorzugsweise mit einer Geschwindigkeit von 1 bis 4 m/min in einer Schichtdicke von vorzugsweise 10 bis 70 µm auf die Unterseite der Leiterplatte (1) aufgetragen.

Bei dieser hochviskosen Beschichtung wird aufgrund der hohen Lackhaftung an der Gummierung nur ein Teil der auf der Auftragswalze befindlichen Lackschicht übertragen. Voraussetzung für die Lackübertragung ist die Haftung an der zu beschichtenden Leiterplattenoberfläche. Da diese auf den Kupferleitern (10) am höchsten ist, wird dort auch die dickste Lackschicht aufgetragen. Die Bohrungen können keine Haftfläche ausbilden und somit wird dort auch kein Lack übertragen. Bei den bisher gebräuchlichen Walzenbeschichtungsverfahren wird der Lack über eine gerillte Gummierung derart aufgebracht, dass der Lack aus den Rillen herausgedrückt wird, wobei auch Lack in die Bohrungen gedrückt wird. Im erfindungsgemäßen Verfahren erfolgt die Beschichtung unabhängig von der Beschaffenheit der zu beschichtenden Oberfläche. Der so aufgetragene Lötstopplack deckt somit die Leiter sehr gut ab und lässt die Bohrungen und die Leiterplattenränder lackfrei, so dass eine gute Lötung der bedrahteten Bauelemente und ein Transport der Leiterplatte in den Trockner gewährleistet ist. Eine Beschädigung der Gummioberfläche durch Einschnitte der hohen Leiter wird durch die erfindungsgemäße Gummierung in Verbindung mit der hohen Beschichtungsviskosität vermieden.

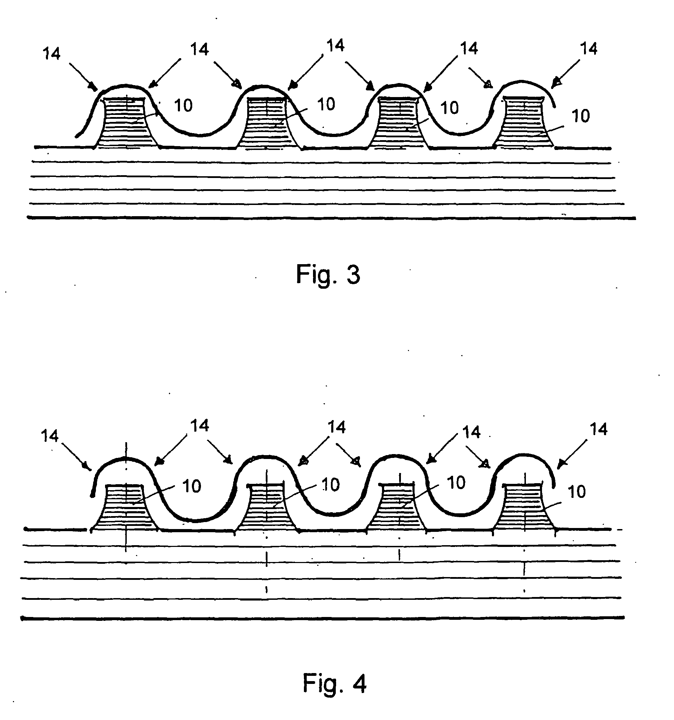

Nach dieser Beschichtung wird die Leiterplatte (1) über Mittel zum Transport der Leiterplatte (7), beispielsweise einen Kettentransport mit Transportklammern, in einen Trockner, beispielsweise einen Infrarottrockner, transportiert, der nur unterhalb der Transportstrecke mit Mitteln zum Trocknen, beispielsweise IR-Strahlern (11), ausgestattet ist. Diese sind mit mittelwelligen Strahlern der Wellenlänge 2 bis 4 µm ausgestattet. Im Gegensatz zu den bisher üblichen Abdunststrecken im Paternosterofen, wo der Lack ohne Viskositätserniedrigung antrocknen soll, damit er nicht durch eine Viskositätserniedrigung von den Leiterkanten abläuft, wird bei dem erfindungsgemäßen Verfahren der gegenteilige Effekt angestrebt. Der Lack soll möglicht schnell in seiner Viskosität von 5.000 bis 15.000 mPa·s auf unter 500 mPa·s erniedrigt werden. Hierdurch glättet sich die zuvor wellige Lackoberfläche und der Lack läuft die Leiterflanken hinauf. Die Freiheit von mineralischen Füllstoffen begünstigt diesen Fließprozess. Die Lacktemperatur sollte in 10 bis 60 Sekunden auf 100 bis 120°C gebracht werden. Durch die einsetzende Trocknung und den damit verbundenen Viskositätsanstieg wird ein Abtropfen vermieden. Die Bohrungen und Härtung und die Ränder bleiben lackfrei. Die danach einsetzende Trocknung führt dann zu einer Verfestigung des Lackes. Nach der Klebfreimachung durch Trocknung und Härtung wird die Leiterplatte (1) in einem Wender (13) gewendet und entweder in der gleichen Anlage ein zweites Mal beschichtet oder einer baugleichen zweiten Walzenbeschichtungsanlage zugeführt. Die Leiter (10) haben, wie in Figur 3 ersichtlich, üblicherweise eine Kantenabdeckung von 5 bis 10 µm bei einer Lackschichtdicke von 30 µm. Bei dem erfindungsgemäßen Verfahren wird, wie in Figur 4 dargestellt, eine Leiterkantenabdeckung (14) von größer 10 µm erzielt.

Dies wird erfindungsgemäß dadurch erreicht, dass der Lack einen Anteil eines hochsiedenden Lösungsmittels mit einem Siedepunkt von größer 120°C in einer Menge von 5 bis 20 Gew.-% enthält und nicht mit mineralischen Füllstoffen ausgestattet ist. Bei dem pulverförmigen Lötstopplack wird dies durch eine Viskositätserniedrigung auf unter 2000, bevorzugt unter 1000, am meisten bevorzugt unter 500 mPa·s erreicht. Diese Freiheit an mineralischen Füllstoffen ermöglicht auch eine Laserstrukturierung ohne pilzartige Ascherückstände auf den Kupferflächen.

Gemäß einer weiteren Ausführungsform weist die Vorrichtung zur Durchführung des erfindungsgemäßen Verfahrens eine weitere Dosierwalze (9) auf. Zwischen den Dosierwalzen (5) und (9) wird aus einem oberhalb der Walzenbeschichtungsanlage (2) angeordneten Vorratsbehälter (6) der hochviskose Lötstopplack zudosiert. Bei Verwendung von thermisch härtbarem pulverförmigen Lötstopplack wird dieser über einen Siebkasten (12) auf die gegenläufig zur Auftragswalze (4) rotierende Dosierwalze (5) aufgetragen. Diese übernimmt den auf der Auftragswalze (4) verbleibenden Lack, auf den dann der pulverförmige Lötstopplack aufgestreut wird. Auf diese Weise wird ein Anhärten vermieden und die Walzenapplikation von thermisch härtbarem pulverförmigem Lötstopplack ermöglicht. Nach der Schichtdickeneinstellung mittels der Dosierwalzen (5) und (9) wird die Lackfreiheit des Randes durch eine auf die stehende Dosierwalze (9) aufgeklebte Folie mit einer Dicke von etwa 30-150 µm erzielt, wobei der Beschichtungsbereich ausgespart ist. Dann wird dieser Lack mit der gegenläufigen Dosierwalze (5) auf die glatte (Rz = 5-10 µm) und weiche (20 bis 40 Shore A) Gummioberfläche der Auftragswalze (4) übertragen und nun mit einer Viskosität von bevorzugt 5.000 bis 15.000 mPa·s mit einer Geschwindigkeit von 1 bis 4 m/min in einer Schichtdicke von 20 bis 70 µm auf die Unterseite der Leiterplatte (1) aufgetragen. Bei der Beschichtung mit thermisch härtbarem, pulverförmigem Lötstopplack werden alle Walzen und die zu beschichtende Leiterplatte auf die Temperatur erwärmt, mit der die erforderliche Beschichtungsviskosität erreicht wird.

Die Erfindung wird durch die nachfolgenden Ausführungsbeispiele näher erläutert:

### Beispiel 1:

Leiterplatte 300 x 420 x 1,5 mm Typ FR 4 nach NEMA Leiterhöhe max. 100 µm Leiterbreite 150 µm

Lötstopplack: Probimer 65 Fa. Vantico AG 100 Gew.T1 + 5 Gew.T1. y-Butyrolacton

Walzenbeschichtungsanlage: RC Fa. Bürkle Gummierung: 100 mm, 30 Shore A, Rz 5 µm
Spaltbreite: 100 µm
Nassauftrag: 50 µm
Geschwindigkeit: 2 m/min
IR-Strahler: erster Strahler 2 µm Wellenlänge, zweiter Strahler 4 µm Wellenlänge
Umlufttemperatur: 120°C
Trocknerlänge: 4 m

### Ergebnis:

Trockenfilmdicke: 30 µm
Kantenabdeckung bei 100 µm Leiterhöhe: 11 µm
Bohrungen Durchmesser 300 bis 1000 µm: lackfrei

### Beispiel 2:

Leiterplatte (2) 300 x 420 x 1,5 mm Typ FR 4 nach NEMA Leiterhöhe max. 100 µm Leiterbreite 150 µm

Lötstopplack (1):
125 Gew.-Tl. Rütapox VE 3746 80 Gew.-% in Methylglykol Fa. Bakelite AG
0,5 Gew.Tl. 2-Ethyl-4-methylimidazol Fa. BASF
Viskosität: 9.500 mPa·s bei 25°C
TG nach Härtung 1 Stunde 160°C: 155°C

Walzenbeschichtungsanlage: RC Fa. Bürkle Gummierung: 100 mm, Härte: 30 Shore A, Rz 5 µm
Spaltbreite: 100 µm
Nassauftrag: 50 µm
Geschwindigkeit: 2 m/min
IR-Strahler: erster Strahler 2 µm Wellenlänge, zweiter Strahler 4 µm Wellenlänge
Umlufttemperatur: 120°C
Trocknerlänge: 4 m
Härtung 160°C 1 Stunde

### Ergebnis Beschichtung:

Trockenfilmdicke: 30 µm
Kantenabdeckung bei 100 µm Leiterhöhe: 11 µm
Bohrungen Durchmesser 300 bis 1000 µm: lackfrei

### Ergebnis Laserstrukturierung:

Kohlendioxidlaser: Lotpads frei von Ascherückständen

### Ergebnis Lötung:

Bohrungen und Lotpads einwandfrei mit Lot benetzt

### Beispiel 3:

Leiterplatte 300 x 420 x 1,5 mm Typ FR 4 nach NEMA Leiterhöhe max. 100 µm Leiterbreite 100 µm

### Lötstopplack

| | |
|---|---|
| 80,0 Gew.Tl. | EPOSID VP 868-2 70 Gew.-%. Duroplast-Chemie |
| 19,5 Gew.Tl. | HAT 9490 Kresolnovolak 100 Gew.% Fa. Vantico |
| 0,5 Gew.Tl. | 2-Ethyl-4-methylimidazol Fa. BASF |
| 100,0 Gew.Tl. | 75 Gew.-% |

| | |
|---|---|
| Viskosität: 7.500 mPa·s bei 25°C TG nach Härtung 1 Stunde 160°C: 150°C | |

Walzenbeschichtungsanlage: RC Fa. Robert Bürkle GmbH Freudenstadt
Gummierung: 100 mm
Härte: 30 Shore A, Rz 5 µm
Spaltbreite: 120 µm
Nassauftrag: 50 µm
Übertrag: 42 Vol.-%
Geschwindigkeit: 2 m/min
IR-Strahler: erster Strahler 2 µm Wellenlänge, zweiter Strahler 4 µm Wellenlänge
Umlufttemperatur: 120°C
Trocknerlänge: 4 m

### Ergebnis:

Trockenfilmdicke: 30 µm
Kantenabdeckung bei 100 µm Leiterhöhe: 11 µm
Bohrungen Durchmesser 300 bis 1000 µm: lackfrei Leitplattenränder: 5 mm lackfrei

### Ergebnis Laserstrukturierung:

Kohlendioxidlaser: Lotpads frei von Ascherückständen Verbrennungsgase: Frei von Halogenen

### Ergebnis Lötung:

Bohrungen und Lotpads einwandfrei mit Lot benetzt

### Beispiel 4:

Leiterplatte 300 x 420 x 1,5 mm Typ FR 4 nach NEMA Leiterhöhe max. 100 µm Leiterbreite 100 µm

Lötstopplack

| | |
|---|---|
| 80,0 Gew.Tl. | EPOSID VP 868-2 70 Gew.-%. Duroplast-Chemie |
| 19,5 Gew.Tl. | HAT 9490 Kresolnovolak 100 Gew.% Fa. Vantico |
| 0,5 Gew.Tl. | 2-Ethyl-4-methylimidazol Fa. BASF |
| 100,0 Gew.T1. | 75 Gew.-% |

### Viskosität: 7.500 mPa·s bei 25°C

Walzenbeschichtungsanlage: RC Fa. Robert Bürkle GmbH Freudenstadt
Gummierung Dicke: 100 mm
Härte: 30 Shore A, Rz 5 µm
Spaltbreite zwischen den Dosierwalzen (5) und (9): 120 µm Nassauftrag: 50 µm
Übertrag: 42 Vol.-%
Teflonfolie über Dosierwalze (9) Aussparung vom rechten
Rand: 410 mm
Geschwindigkeit: 2 m/min
IR-Strahler: erster Strahler 2 µm Wellenlänge, zweiter Strahler 4 µm Wellenlänge
Umlufttemperatur: 120°C
Trocknerlänge: 4 m

### Beispiel 5:

Leiterplatte 300 x 420 x 1,5 mm Typ FR 4 nach NEMA Leiterhöhe max. 100 µm Leiterbreite 100 µm

Pulverförmiger Lötstopplack:

| | |
|---|---|
| 95,00 Gew.T1. | Epoxidharz DER 671 Fa. Dow Chemical |
| 4,5 Gew.Tl. | Dicyandiamid |
| 0,5 Gew.Tl. | 2-Methylimidazol Fa. BASF |
| 100,0 Gew.Tl. | Pulverförmiger Lötstopplack |

Schmelzbereich: 65-78°C
Viskosität: 14.00 mPa·s bei 110°C
Korngröße: 10-20 µm
TG nach der Härtung 1 Stunde 160°C: 160°C

Walzenbeschichtungsanlage: H RC Fa. Robert Bürkle GmbH Freudenstadt
Gummierung: 10 mm
Härte: 30 Shore A, Rz 5 µm
Temperatur der Auftragswalze (4) und der Dosierwalzen (5) und (9): 110°C
Temperatur der Leiterplatte: 110°C
Teflonfolie über Dosierwalze (9) Aussparung vom rechten
Rand: 410 mm
Spaltbreite zwischen den Dosierwalzen (5) und (9): 50 µm
Trockenauftrag: 30 µm
Übertrag: 60 Vol.-%
Geschwindigkeit: 3 m/min
IR-Strahler: erster Strahler 2 µm Wellenlänge, zweiter Strahler 4 µm Wellenlänge
Umlufttemperatur: 140°C
Trocknerlänge: 4 m

### Ergebnis:

### Erste Beschichtung:

Trockenfilmdicke: 30 µm
Kantenabdeckung bei 100 µm Leiterhöhe: 11 µm
Bohrungen Durchmesser 300 bis 1000 µm: lackfrei Leitplattenränder: 5 mm lackfrei
Ergebnis:

### Zweite Beschichtung:

Trockenfilmdicke: 30 µm
Kantenabdeckung bei 100 µm Leiterhöhe: 12 µm Bohrungen Durchmesser 300 bis 1000 µm: lackfrei Leitplattenränder: 5 mm lackfrei

### Ergebnis Laserstrukturierung:

Kohlendioxidlaser: Lotpads frei von Ascherückständen Verbrennungsgase: Frei von Halogenen

### Ergebnis Lötung:

Bohrungen und Lotpads einwandfrei mit Lot benetzt

## Patentansprüche

1. Vorrichtung zur Beschichtung von Leiterplatten (1) mit einem Lötstopplack bzw. Galvanoresist, umfassend mindestens eine Walzenbeschichtungsanlage (2) mit einer oberen gummierten Führungswalze (3), einer unteren gummierten Auftragswalze (4), einer mit der Auftragswalze (4) einen Dosierspalt ausbildenden Dosierwalze (5), einem oberhalb der Walzenbeschichtungsanlage (2) angeordneten Vorratsbehälter (6) für den Lötstopplack bzw. Galvanoresist, Mittel zum Transport der Leiterplatten (7), Mittel zum Trocknen des Lötstopplacks (11) und eine Einrichtung zum Wenden der beschichteten Leiterplatten, wobei die Walzenbeschichtungsanlage (2) nur über eine Beschichtungseinheit zur Beschichtung der Leiterplattenunterseite verfügt.

2. Vorrichtung nach Anspruch 1, **dadurch gekennzeichnet, dass** die Auftragswalze (4) eine Härte von 20 bis 40 Shore A und eine Rauigkeit R_{z} von 5 bis 10 µm besitzt.

3. Vorrichtung nach Anspruch 1, **dadurch gekennzeichnet, dass** sie zwischen der Auftragswalze (4) und der Dosierwalze (5) eine keilförmige Rakel (8) aufweist.

4. Vorrichtung nach Anspruch 1, **dadurch gekennzeichnet, dass** sie eine weitere Dosierwalze (9) aufweist, die mit der ersten Dosierwalze (5) einen Dosierspalt ausbildet, über dem sich der Vorratsbehälter (6) oder ein Siebkasten (12) für Pulverlacke befindet.

5. Vorrichtung nach Anspruch 1 oder 4, **dadurch gekennzeichnet, dass** die Dosierwalzen (5, 9) beheizbar sind.

6. Vorrichtung nach Anspruch 4 oder 5, **dadurch gekennzeichnet, dass** die Dosierwalze (9) als stehende Dosierwalze ausgebildet ist, die mit einer Kunststofffolie derart ummantelt ist, dass gewünschte Beschichtungsbereiche durch das Abziehen der Folie freigelegt werden können.

7. Verfahren zur Beschichtung von Leiterplatten (1) mit einem Lötstopplack bzw. Galvanoresist, umfassend die folgenden Stufen:
(i) Zuführen der Leiterplatte (1) zu einer Walzenbeschichtungsanlage, wobei die Walzenbeschichtungsanlage nur über eine Beschichtungseinheit zur Beschichtung der Substratunterseite verfügt,
(ii) Zudosieren des Lötstopplacks bzw. Galvanoresists mit einer Viskosität von 4.000-15.000 mPa·s bei 25°C oder eines Pulverlacks,
(iii) Auftragen des Lacks auf die Unterseite der Leiterplatte (1),
(iv) Trocknen der beschichteten Leiterplatte (1) für einen Zeitraum und bei einer Temperatur, die ausreichend sind, um die Viskosität des Lacks auf unter 300 mPa-s bzw. des Pulverlacks auf unter 500 mPa·s zu erniedrigen, den Lack zu verfestigen und klebfrei zu machen, und
(v) Wenden der Leiterplatte und Durchführen der Stufen (i) bis (iv) in derselben oder einer weiteren Walzenbeschichtungsanlage.

8. Verfahren nach Anspruch 7, **dadurch gekennzeichnet, dass** man Stufe (iv) bei einer Temperatur von 100-120°C über einen Zeitraum von 10 Sekunden bis 1 Minute durchführt.

9. Verfahren nach Anspruch 7, **dadurch gekennzeichnet, dass** der Lack bei einer Walzengeschwindigkeit von 0.2-4 m/min, bevorzugt 0.5-4 m/min, am meisten bevorzugt 1-4 m/min in einer Schichtdicke von 10-100 µm aufgetragen wird.

10. Verfahren nach Anspruch 7, **dadurch gekennzeichnet, dass** man als Lack bzw. Galvanoresist einen Lack bzw. Galvanoresist verwendet, der einen Festkörpergehalt von 50-100 Gew.-% und eine Viskosität von 5.000-15.000 mPa·s aufweist.

11. Verfahren nach Anspruch 10, **dadurch gekennzeichnet, dass** der Lack bzw Galvanoresist im Wesentlichen frei von Füllstoffen ist.

12. Verfahren nach Anspruch 10 oder 11, **dadurch gekennzeichnet, dass** der Lack bzw. Galvanoresist thermisch härtbar oder strahlenhärtbar ist.

13. Verfahren nach den Ansprüchen 10 bis 12, **dadurch gekennzeichnet, dass** der Lack bzw. Galvanoresist halogenfrei ist.

14. Verfahren nach Anspruch 10, **dadurch gekennzeichnet, dass** der Lack bzw. Galvanoresist einen Anteil an über 120°C siedenden Lösungsmitteln von 5-20 Gew.-% enthält.

15. Verfahren nach Anspruch 10, **dadurch gekennzeichnet, dass** der Lack bzw. Galvanoresist ein halogenfreies Epoxydharz umfasst.

16. Verfahren nach Anspruch 10, **dadurch gekennzeichnet, dass** der Lötstopplack ein thermisch härtbarer, pulverförmiger Lötstopplack ist, der eine Viskosität von 10.000-15.000 mPa·s bei einer Temperatur von 80-120°C aufweist.

17. Mittels Laser strukturierbarer Lötstopplack und Galvanoresist, der einen Festkörpergehalt von 50-100 Gew.-% und eine Viskosität von 10.000-15.000 mPa·s bei einer Temperatur von 80-120°C aufweist, **dadurch gekennzeichnet, dass** er ein thermisch härtbarer, pulverförmiger Lötstopplack ist.

## Claims

1. An apparatus for coating printed circuit boards (1) with a solder stop lacquer or an electroresist, comprising at least one roll coating apparatus (2) having an upper rubber-coated guide roll (3), a lower rubber-coated applicator roll (4), a metering roll (5) forming a metering gap together with the applicator roll (4), a storage container (6) for the solder stop lacquer or the electroresist arranged above the roll coating apparatus (2), means for transporting the printed circuit boards (7), means for drying the solder stop lacquer (11) and a device for turning the coated printed circuit boards, said roll coating apparatus (2) having only a coating unit for coating the bottom side of the printed circuit boards.

2. An apparatus according to claim 1, **characterized in that** the applicator roll (4) has a hardness of 20 to 40 Shore A and a roughness R_{z} of 5 to 10 µm.

3. An apparatus according to claim 1, **characterized in that** the apparatus has a wedge-shaped coating knife (8) between the applicator roll (4) and the metering roll (5).

4. An apparatus according to claim 1, **characterized in that** the apparatus has a further metering roll (9) forming a metering gap with the first metering roll (5), above which the storage container (6) or a screen case (12) for powder coatings is located.

5. An apparatus according to claim 1 or 4, **characterized in that** the metering rolls (5, 9) are heatable.

6. An apparatus according to claim 4 or 5, **characterized in that** the metering roll (9) is a fixed metering roll being coated with a plastic film in such a way that the desired coating regions can be set free by peeling off the film.

7. A process for coating printed circuit boards (1) with a solder stop lacquer or an electroresist, comprising the following steps:
(i) supplying the printed circuit board (1) to a roll coating apparatus having only a coating unit for coating the bottom side of the substrate,
(ii) metering the solder stop lacquer or electroresist having a viscosity of 4000-15000 mPa·s at 25°C or metering a powder coating,
(iii) applying the lacquer onto the bottom side of the printed circuit board (1),
(iv) drying the coated printed circuit board (1) for a period and at a temperature sufficient to reduce the viscosity of the lacquer below 300 mPa·s or to reduce the viscosity of the powder coating under 500 mPa·s, to harden the lacquer and to render it non-tacky, and
(v) turning the printed circuit board and performing steps (i) to (iv) in the same roll coating apparatus or in a further roll coating apparatus.

8. A process according to claim 7, **characterized in that** step (iv) is carried out at a temperature of 100-120°C over a period of 10 seconds to 1 minute.

9. A process according to claim 7, **characterized in that** the lacquer is applied at a roll speed of 0.2-4 m/min, preferably 0.5-4 m/min, most preferably 1-4 m/min in a layer thickness of 10-100 µm.

10. A process according to claim 7, **characterized in that** a lacquer or an electroresist having a solids content of 50-100% by weight and a viscosity of 5000-15000 mPa·s is used as the lacquer or the electroresist.

11. A process according to claim 10, **characterized in that** the lacquer or the electroresist is essentially free of fillers.

12. A process according to claim 10 or 11, **characterized in that** the lacquer or the electroresist is thermally curable or curable by irradiation.

13. A process according to claims 10 to 12, **characterized in that** the lacquer or the electroresist is halogen-free.

14. A process according to claim 10, **characterized in that** the lacquer or the electroresist has a content of solvents having a boiling point above 120°C of 5-20% by weight.

15. A process according to claim 10, **characterized in that** the lacquer or the electroresist comprises a halogen-free epoxy resin.

16. A process according to claim 10, **characterized in that** the solder stop lacquer is a thermally curable, powdery solder stop lacquer having a viscosity of 10000-15000 mPa·s at a temperature of 80-120°C.

17. Laser structurable solder stop lacquer and electroresist which has a solids content of 50-100% by weight and a viscosity of 10000-15000 mPa·s at a temperature of 80-120°C, **characterized in that** it is a thermally curable, powdery solder stop lacquer.

## Revendications

1. Dispositif pour le revêtement de cartes imprimées (1) avec une laque d'arrêt de soudure ou un galvanoresist, comprenant au moins une installation à enduction au rouleau (2) avec un rouleau de guidage supérieur caoutchouté (3), un rouleau d'application inférieur caoutchouté (4), un rouleau de dosage (5) constituant avec le rouleau d'application (4) une fente de dosage, un conteneur de réserve (6) placé au-dessus de l'installation à enduction au rouleau (2) pour la laque d'arrêt de soudure ou le galvanoresist, des moyens de transport des cartes imprimées (7), des moyens de séchage de la laque d'arrêt de soudure (11) et un dispositif pour tourner les cartes imprimées enduites de revêtement, l'installation à enduction au rouleau (2) ne disposant que d'une unité de revêtement pour le revêtement de la face inférieure de la carte imprimée.

2. Dispositif selon la revendication 1, **caractérisé en ce que** le rouleau d'application (4) possède une dureté de 20 à 40 Shore A et une rugosité R_{z} de 5 à 10 µm.

3. Dispositif selon la revendication 1, **caractérisé en ce qu'**il présente entre le rouleau d'application (4) et le rouleau de dosage (5) un racloir en forme de coin (8).

4. Dispositif selon la revendication 1, **caractérisé en ce qu'**il présente un autre rouleau de dosage (9), qui constitue avec le premier rouleau de dosage (5) une fente de dosage, au-dessus de laquelle se trouve le conteneur de réserve (6) ou une caisse de tamisage (12) pour de la laque en poudre.

5. Dispositif selon la revendication 1 ou 4, **caractérisé en ce que** les rouleaux de dosage (5, 9) peuvent être chauffés.

6. Dispositif selon la revendication 4 ou 5, **caractérisé en ce que** le rouleau de dosage (9) est conçu comme rouleau de dosage vertical, qui est enveloppé d'une feuille de matière plastique de façon à ce que des zones de revêtement souhaitées puissent être libérées par l'enlèvement de la feuille.

7. Procédé pour le revêtement de cartes imprimées (1) avec une laque d'arrêt de soudure ou de galvanoresist, comprenant les étapes suivantes:
(i) guidage de la carte imprimée (1) vers une installation à enduction au rouleau, l'installation à enduction au rouleau ne disposant que d'une unité de revêtement pour le revêtement de la face inférieure du substrat,
(ii) dosage de la laque d'arrêt de soudure ou du galvanoresist avec une viscosité de 4.000 à 15.000 mPa·s à 25°C ou d'une laque en poudre,
(iii) application de la laque sur la face inférieure de la carte imprimée (1),
(iv) séchage de la carte imprimée enduite de revêtement (1) pendant un intervalle de temps et à une température suffisants pour abaisser la viscosité de la laque à moins de 300 mPa·s ou de la laque en poudre à moins de 500 mPa·s, pour figer la laque et la rendre non adhérente, et
(v) tournage de la carte imprimée et exécution des étapes (i) à (iv) dans la même ou dans une autre installation à enduction au rouleau.

8. Procédé selon la revendication 7, **caractérisé en ce que** l'on exécute l'étape (iv) à une température de 100 à 120°C sur un intervalle de temps de 10 secondes à 1 minute.

9. Procédé selon la revendication 7, **caractérisé en ce que** la laque est appliquée à une vitesse de rouleau de 0,2 à 4 m/min, de préférence de 0,5 à 4 m/min, encore mieux de 1 à 4 m/min dans une épaisseur de couche de 10 à 100 µm.

10. Procédé selon la revendication 7, **caractérisé en ce que** l'on utilise comme laque ou galvanoresist une laque ou un galvanoresist qui présente un extrait sec de 50 à 100 % de la masse initiale et une viscosité de 5.000 à 15.000 mPa·s.

11. Procédé selon la revendication 10, **caractérisé en ce que** la laque ou le galvanoresist est essentiellement exempt d'agents de remplissage.

12. Procédé selon la revendication 10 ou 11, **caractérisé en ce que** la laque ou le galvanoresist peut être thermodurcissable ou radiodurcissable.

13. Procédé selon les revendications 10 à 12, **caractérisé en ce que** la laque ou le galvanoresist est sans halogène.

14. Procédé selon la revendication 10, **caractérisé en ce que** la laque ou le galvanoresist contient une proportion de 5 à 20 % par rapport à la masse initiale, en solvants en ébullition au-dessus de 120°C.

15. Procédé selon la revendication 10, **caractérisé en ce que** la laque et/ou le galvanoresist comprend une résine époxy sans halogène.

16. Procédé selon la revendication 10, **caractérisé en ce que** la laque d'arrêt de soudure est une laque d'arrêt de soudure thermodurcissable, sous forme de poudre, qui présente une viscosité de 10.000 à 15.000 mPa·s à une température de 80 à 120°C.

17. Laque d'arrêt de soudure et galvanoresist structurables par laser, qui présentent un extrait sec de 50 à 100 % par rapport à la masse initiale et une viscosité de 10.000 à 15.000 mPa·s à une température de 80 à 120°C, **caractérisés en ce qu'**il s'agit d'une laque d'arrêt de soudure thermodurcissable, sous forme de poudre.
